# EUROPEAN PATENT APPLICATION

(11) **EP 2 437 247 A1**
(43) Date of publication of application: **04.04.2012**
(21) Application number: 10185569.0
(22) Date of filing: 01.10.2010
(51) Int. Cl.: G09G 3/32, G11C 11/22, H01L 27/28, H01L 51/05

(54) **Display**

(71) Applicant: Nederlandse Organisatie voor Toegepast -Natuurwetenschappelijk Onderzoek TNO, 2628 VK Delft (NL); IMEC vzw, 3001 Leuven-Heverlee (BE)
(72) Inventor: Gelingk, Gerwin Hermanus, 5551 HT Valkenwaard (NL)
(74) Representative: Jansen, Cornelis Marinus

(57) **Abstract**

A display comprising: an array of pixel units, each comprising a light emitting diode (LED) programmable between a first state in which it emits light when forward biased above its turn-on voltage and a second state in which it does not emit light when forward biased above its turn-on voltage; an addressing unit by which the pixel units are addressed; and a controller operable to control the addressing unit to apply, in a first phase, drive voltages across the LEDs which program their state, and in a second phase, drive voltages across the LEDs above their turn-on voltages.

## Description

The present invention relates to a display that uses light emitting diodes (LEDs) and, more particularly, but not exclusively, organic light emitting diodes (OLEDs) as electroluminescent elements.

The simplest and lowest cost form of LED display is the passive matrix LED display. In a conventional passive matrix OLED display, the image is built up in generally the same manner as in a traditional CRT-based television. Each line of the image is written sequentially and flashes brightly for a short time. This is achieved by holding all the LEDs in reverse bias other than the line being addressed, which is set to a lower voltage. Due to the diode characteristic, it is possible to multiplex a LED display as much as is desired without diminishing the image quality. By scanning the lines sufficiently quickly (to create about 60 pictures per second), the eye will integrate all the light flashes into a series of time-averaged images, as occurs when viewing a traditional CRT-based television. A shortcoming of generating a picture in this way is that in order to obtain normal picture brightness, the light pulses have to be extremely bright because they are only present for a short time. In a 100-line display, for example, the light pulses have to flash with a peak luminance that is 100 times the average luminance that is actually perceived. This means that high currents and voltages are needed to generate the light pulses, which in turn results in high power dissipation in the electrodes of the displays. Since this dissipated power is not being used to produce light, the display efficiency is poor. In addition, the power dissipation and the high peak brightness tend to limit the lifetime of the display. Furthermore, as the size of the display increases, the peak luminance requirement also increases, whereby, for larger displays, the above mentioned problems are exasperated.

Another form of LED display is the active matrix thin-film transistor (TFT) display. These displays overcome the above-mentioned shortcoming inherent to conventional passive matrix displays by having a memory and a controlled current source associated with each pixel so that an individual OLED can be kept in an emitting state or not as dictated by the state of the memory even outside of the addressing period. This reduces the peak currents, which in turn reduces the power dissipation and the efficiency and lifetime demands on the OLEDs. Usually the process to fabricate the transistors requires 4-6 mask steps, accurate overlay registration and minimum feature sizes of a few micrometers. A minimum of two TFTs are needed for continuous operation and a uniform current level to every pixel is needed for display uniformity. The basic components required are a select transistor, a drive transistor, which acts as the current source, and a storage capacitor. Row selection turns on the select transistor which then transfers the data voltage from the column electrode to the gate of the drive transistor. The select transistor is switched off leaving the data voltage on the drive transistor for the remainder of the frame period, and the storage capacitor prevents discharge of the drive transistor gate voltage. This results in continuous emission from the pixel during the frame period. Although the use of a TFT backplane allows better displays, it significantly increases the cost of the display.

With this background in mind, according to a first aspect, the present invention may provide a display comprising:
an array of pixel units, each comprising a light emitting diode (LED) programmable between a first state in which it emits light when forward biased above its turn-on voltage and a second state in which it does not emit light when forward biased above its turn-on voltage;
an addressing unit by which the pixel units are addressed; and
a controller operable to control the addressing unit to apply, in a first phase, drive voltages across the LEDs which program their state, and in a second phase, drive voltages across the LEDs above their turn-on voltages.

A display in accordance with the present invention enables those LEDs in the second state to emit continuously in the second phase. As a result, there is no requirement for an elevated peak luminance.

Preferably, the addressing unit comprises a column driver and a row driver. Preferably, the array of pixel units is arranged as a cross point array in which the pixel units are addressable via M column electrodes connected to the column driver and N row electrodes connected to the row driver. Preferably, the column electrodes and the row electrodes are orthogonally patterned. In other embodiments, the addressing unit comprises a direct-addressing circuit comprising MxN lines.

Preferably, each LED is programmable by at least one state-programming voltage. Most preferably, each LED is programmable by a first state-programming voltage for putting the LED into the first state and by a second state-programming voltage for putting the LED into the second state.

Preferably, the controller constructs a set of drive signals to be applied via the column driver and the row driver so as to produce said drive voltages. Various schemes of drive signals are presented in the preferred embodiments, each enjoying different benefits and trade-offs.

In one embodiment, said array of pixel units constitutes all the pixel units of the display. In other embodiments, the display comprises more than one of said arrays of pixel units, and the controller is operable to perform said first phase addressing to a first of said arrays while performing said second phase addressing to a second of said arrays.

In one embodiment, the display further comprises a liquid crystal display (LCD) element or other display medium, and the array of pixel elements is arranged to provide the backlighting thereto.

Preferably, a said LED comprises an organic light emitting diode (OLED).

According to a second aspect, the present invention may provide a method of driving a display comprising an array of pixel units, each comprising a LED programmable between a first state in which it emits light when forward biased above its turn-on voltage and a second state in which it does not emit light when forward biased above its turn-on voltage, comprising applying, in a first phase, drive voltages across the LEDs which program their state, and in a second phase, drive voltages across the LEDs above their turn-on voltages.

Preferably, the pixel units are arranged as a M by N cross point array addressable via M+N electrodes.

According to a further aspect, the present invention may provide a display comprising an array of pixel units, each comprising a LED programmable between a first state in which it emits light when forward biased above its turn-on voltage and a second state in which it does not emit light when forward biased above its turn-on voltage, the display being operable such that, in a first phase, drive voltages are applied across the LEDs to program their state, and in a second phase, drive voltages are applied across the LEDs above their turn-on voltages.

Exemplary embodiments are hereinafter described with reference to the accompanying drawings, in which:
Figure 1 shows schematically a display in accordance with an embodiment of the present invention;
Figure 2 shows a diagram of the display of Figure 1 illustrating its operation according to a first driving scheme;
Figure 3 shows a diagram of the display of Figure 1 illustrating its operation according to a second driving scheme;
Figure 4 shows a diagram of the display of Figure 1 illustrating its operation according to a third driving scheme; and
Figure 5 shows a diagram of a display divided up into multiple regions.

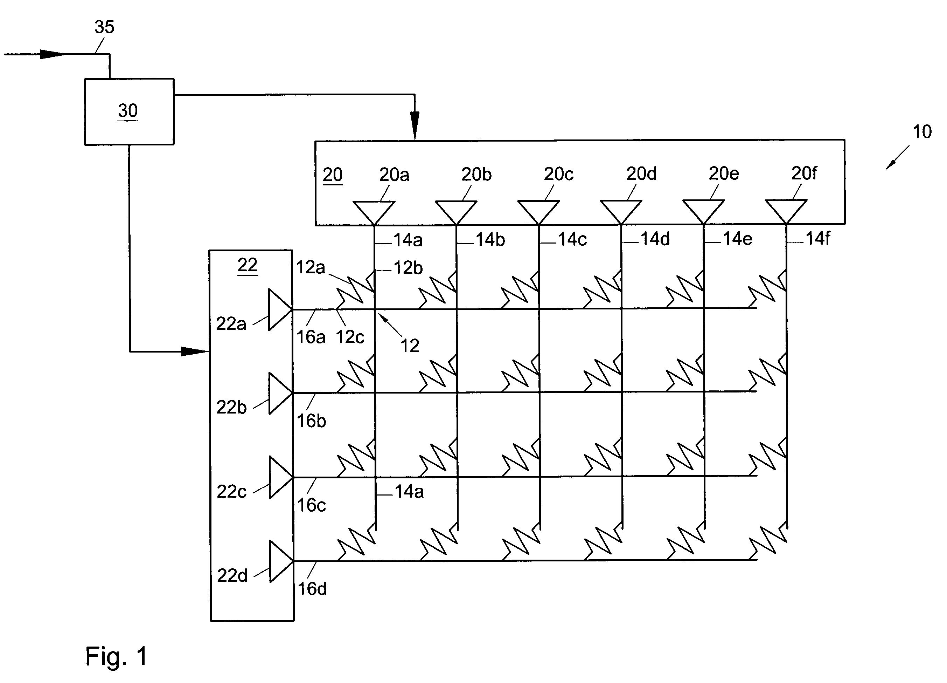

A display 10 in accordance with an embodiment of the present invention is shown in Figure 1.

The display 10 comprises an M by N array of pixel units 12 formed on a substrate (not shown). For the purposes of illustration in Figure 1, M=6, N=4. The pixel units 12 each comprise an OLED 12a having two terminals, an anode terminal 12b and a cathode terminal 12c. The pixel units 12 are arranged as a cross point array having M column, anode electrodes 14a-f that each connect the anode terminals 12b of a column of the pixel units 12 in parallel and N row, cathode electrodes 16a-d that each connect the cathode terminals of a row of the pixel units 12 in parallel. The display 10 further comprises a column driver 20 comprising a plurality of column driver circuits 20a-f each connected to a respective column electrode 14a-f and a row driver 22 comprising a plurality of row driver circuits 22a-d each connected to a respective row electrode 16a-d.

The drivers 20,22 provide the means by which the pixel units 12 are addressed. The display 10 further comprises a controller 30 which receives image data 35 and directs the operation of the column and row drivers 20,25 according to a selected one of a plurality of driving schemes which are described later.

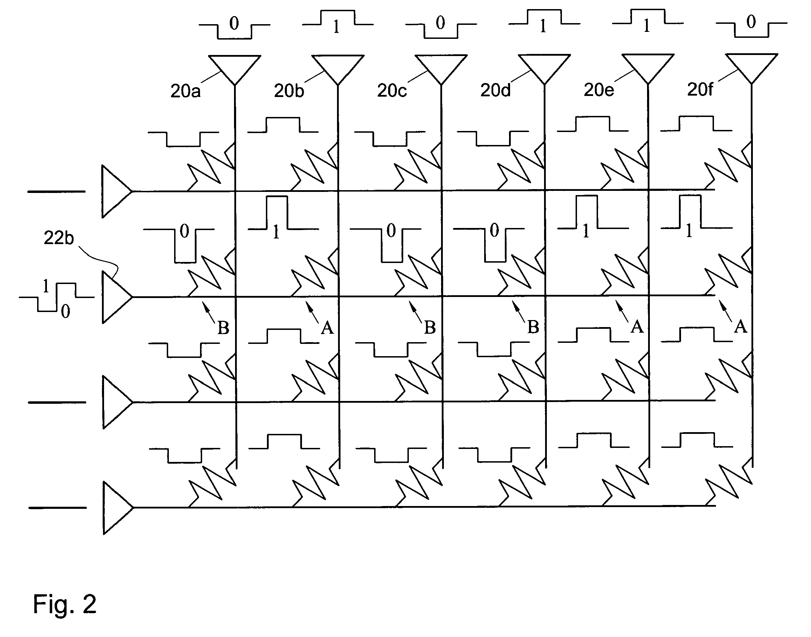

Each OLED 12a has two intrinsic states that are programmable. The states are non-volatile, whereby they do not change absent any voltage applied across the terminals of the OLED 12a, but only in response to a predetermined state-programming voltage. Examples of such devices are disclosed in EP1995736, WO2008/143509 and EP2192636. Each OLED 12a can be programmed into a first state (corresponding to "1" in Figures 2 to 5) by applying a first state-programming voltage above a first predetermined threshold across its terminals; in this embodiment, the first predetermined threshold equates to a maximum positive voltage pulse across its terminals. Each OLED 12a can be programmed into a second state (corresponding to "0" in Figures 2 to 5) by applying a second state-programming voltage below a second predetermined threshold across its terminals; in this embodiment, the second predetermined threshold equates to a maximum negative voltage pulse across its terminals. Each OLED 12a remains in the same state when applying smaller magnitude (positive or negative) voltages across its terminals. In the first state (the low resistive state), when the voltage applied across its terminals is lower than the magnitude of either of the state-programming voltages, the OLED emits light as long as the applied voltage creates a forward bias above its turn-on voltage. In the second state (the high resistive state), when a similar voltage is applied across its terminals, the OLED emits almost no light.

The controller 30 responsive to the image data 35 constructs a set of drive signals to be applied to the array of pixel units 12 in order to create the desired pattern of light emissions from the display 10. In a first phase of relatively short duration, the fast writing of the so-called virtual image takes place. In this first phase, the drive signals are constructed such that drive voltages are applied across each of the OLEDs 12a which program them into a selected one of the first and second states. In a second phase of relatively long duration, all the OLEDs 12a are forward biased above their turn-on voltages to allow them to continuously emit light if they happen to be in the first state.

From the foregoing, it will be appreciated that the display 10, while keeping essentially the same simple architecture as a conventional passive matrix OLED display, is driven in a manner in which the pixel units 12 emit light almost continuously, i.e. continuously in the relatively long second phase. In so doing, there is no requirement of an elevated peak brightness and so the previously mentioned problems concerning power dissipation and limited display lifetime are reduced. Since the power losses are so reduced, the display 10 is particularly suited to making large displays. The optimum voltage difference in the second phase depends on the required brightness, brightness difference between emitting and non-emitting pixels, endurance, refresh frequency and is therefore largely depended on the I-V-L characteristics of the OLED 12a. The exact timing of the first and second phase depends on many factors, including the volatility of the programmed state, and is application specific. It is particularly noteworthy that the power reduction becomes more significant with increasing the duration of the second phase. This makes this embodiment particularly suitable for signage applications or other application where rapid updating of images is not a priority.

During the first phase, various schemes, enjoying different benefits and trade-offs, may be employed for programming the pixel units 12 to carry out the writing of the image. Three exemplary schemes are now described. Other variant and intermediate schemes are possible.

According to a first scheme shown in Figure 2, the array is written on a row-by-row basis with all the column driver circuits 20a-f holding the required bit values to be written throughout the period in which the current active row is being written to. Thus, at the moments shown in Figure 2, the second row is active and is to be written with the bit values held by the column driver circuits 20a-f. Then, the active second row is driven by the row driver circuit 22b to a low voltage to program the "1" values in the required pixel units 12. This causes the OLEDs labelled A to be subjected to a positive voltage across their terminals that is greater than the first threshold, whereby the OLEDs A enter the first state. All other OLEDs, both in the active row and outside the active row, do not receive sufficient voltage across their terminals for a state change. Next, the active second row is driven to a high voltage to program the "0" values in the selected pixel units 12. This causes the OLEDs labelled B to be subjected to a negative voltage across their terminals that is lower than the second threshold, whereby the OLEDs B enter the second state. All other OLEDs, both in the active row and outside the active row, do not receive sufficient voltages across their terminals for a state change. This process is repeated for all the rows. In this way, the states of all the OLEDs are programmed during this first phase. For those OLEDs that were already in the first state, then the changes in voltage applied during this first phase may cause variations in the light emitted. But since overall the first phase takes place very quickly, this will not be perceived by the eye as flickering. The required half-write endurance for this approach is about 2Nsel times the normal full-write endurance because the half-write pulses are twice as long as the actual write pulses. An active row driver circuit has to be able to sink the currents to write at most all N_{dat} ones, and to source the current to write at most all N_{dat} zeroes. An active row driver circuit has to withstand the corresponding current density, so the pixel resistance Plow has a lower bound. Inactive row driver circuits have to sink or source at most N_{dat} "half" currents.

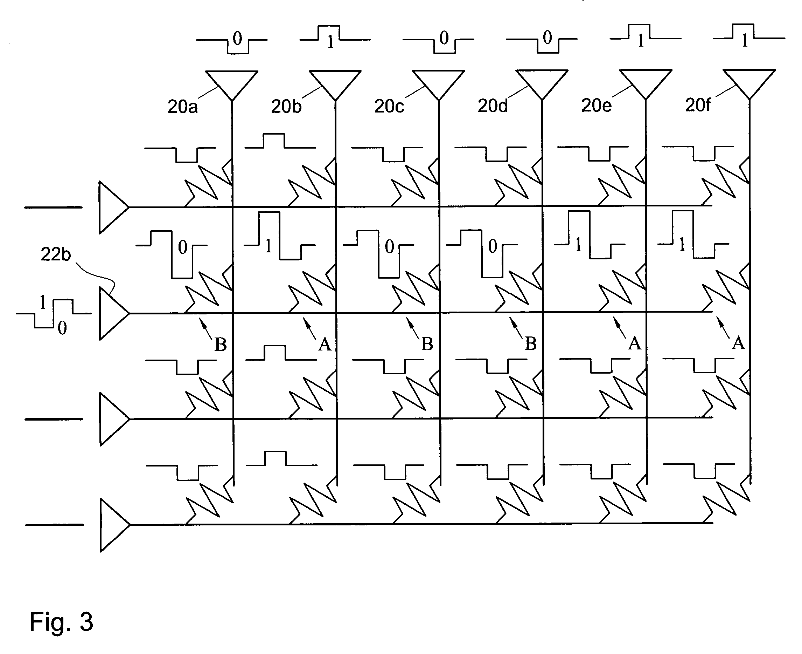

According to a second scheme shown in Figure 3, again the array is written on a row-by-row basis. But, in this case, the column driver circuits 20a-f hold the required bit value only when the currently active second row driver 22b writes the corresponding state. This process is repeated for all rows. The required maximum source and sink currents are unaffected, but the unselected pixels see half-write signals only half the time, while the selected pixels always see either the full or the half-write signal. The required half-write endurance is therefore Nₛₑₗ times the normal full-write endurance. Depending on the details of the drivers 20,22 and the pixel units 12, this approach will generally give a slightly lower power consumption because some energy is saved in respect of unselected pixel units 12.

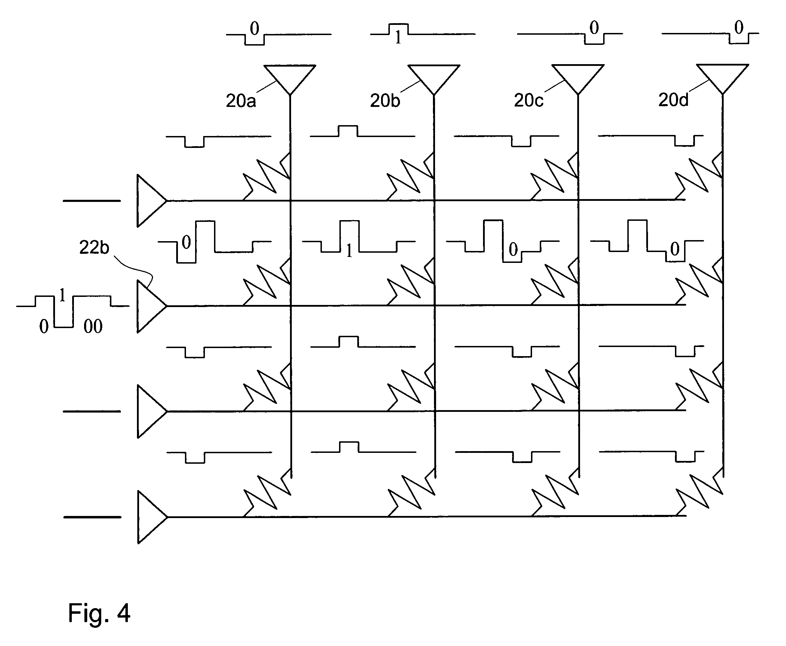

According to a third scheme shown in Figure 4, maximum drive currents can be reduced significantly by programming each pixel unit 12 sequentially. The column driver circuits 20a-d (only 4 are shown in Figure 4) are activated one by one at the required state. The currently active second row driver circuit 22b sequentially writes the inverse voltage required for each bit value. The required half-write endurance is about Nₛₑₗ+N_{dat} times the normal full write endurance. The active second row driver circuit 22b has to source or sink only one full write current plus N_{dat}-1 half-write currents, while the inactive row driver circuits 22a,c,d always have to source or sink only a single half-current. This process is repeated for all rows.

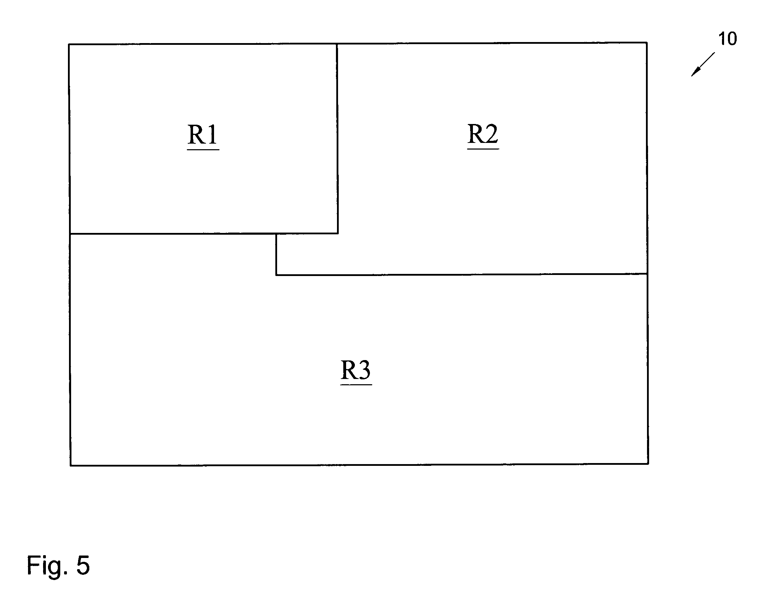

In the above described embodiments, the first phase addressing is carried out on all the pixel units 12 of a display 10. In other embodiments, the display 10 may, for the purposes of applying the first and second phase addressing, be divided into sub-regions R1-3 as shown in Figure 5. In such an embodiment, the controller 30 may be operable to perform the first phase addressing to a first array comprising region R1 while performing the second phase addressing to a second array comprising region R2 or R3. The controller 30 then may be operable to perform the second phase addressing to the first array comprising region R1 while performing the first phase addressing to the second array comprising region R2 or R3. By dividing the display 10 into sub-regions, each sub-region may be refreshed, i.e. undergo first phase addressing, at a different frequency. This may be beneficial in, for example, large signage where it is known a priori that a certain region will contain an image requiring only infrequent updating and another region will contain an image requiring more frequent updating. In other embodiments, each sub-region of a display need not be refreshed at different frequencies, but merely at time-offset intervals. This might be useful in the case of a very large display 10.

## Claims

1. A display comprising:
an array of pixel units, each comprising a light emitting diode (LED) programmable between a first state in which it emits light when forward biased above its turn-on voltage and a second state in which it does not emit light when forward biased above its turn-on voltage;
an addressing unit by which the pixel units are addressed; and
a controller operable to control the addressing unit to apply, in a first phase, drive voltages across the LEDs which program their state, and in a second phase, drive voltages across the LEDs above their turn-on voltages.

2. A display as in claim 1, wherein the addressing unit comprises a column driver and a row driver.

3. A display as in claim 2, wherein the array of pixel units is arranged as a cross point array in which the pixel units are addressable via M column electrodes connected to the column driver and N row electrodes connected to the row driver.

4. A display as in any preceding claim, wherein each LED is programmable by at least one state-programming voltage.

5. A display as in claim 4, wherein each LED is programmable by a first state-programming voltage for putting the LED into the first state and by a second state-programming voltage for putting the LED into the second state.

6. A display as in any of claims 2 to 5, wherein the controller constructs a set of drive signals to be applied via the column driver and the row driver so as to produce said drive voltages.

7. A display as in claim 6, wherein the array is written on a row-by-row basis and the column driver holds the required bit values to be written to the active row throughout which the active row is active.

8. A display as in claim 6, wherein the array is written on a row-by-row basis and the column driver holds the required bit values to be written to the active row only when the active row writes a state corresponding to the required bit values.

9. A display as in claim 8, wherein each pixel unit in the array is written individually and sequentially.

10. A display as in any preceding claim, wherein the display comprises more than one of said arrays of pixel units, and the controller is operable to perform said first phase addressing to a first of said arrays while performing said second phase addressing to a second of said arrays.

11. A display as in any preceding claim, wherein the display further comprises a liquid crystal display (LCD) element or other display medium, and the array of pixel elements is arranged to provide the backlighting thereto.

12. A display as in any preceding claim, wherein a said LED comprises an organic light emitting diode (OLED).

13. A method of driving a display comprising an array of pixel units, each comprising a light emitting diode (LED) programmable between a first state in which it emits light when forward biased above its turn-on voltage and a second state in which it does not emit light when forward biased above its turn-on voltage, comprising applying, in a first phase, drive voltages across the LEDs which program their state, and in a second phase, drive voltages across the LEDs above their turn-on voltages.

14. A method as in claim 13, wherein the pixel units are arranged as a M by N cross point array addressable via M+N electrodes.
